# EUROPEAN PATENT APPLICATION

(11) **EP 3 208 070 A1**
(43) Date of publication of application: **23.08.2017**
(21) Application number: 15850483.7
(22) Date of filing: 09.10.2015
(51) Int. Cl.: B29C 65/02, B29C 65/14

(54) **WORKPIECE BONDING METHOD**

(30) Priority: 15.10.2014 JP 2014210646
(71) Applicant: Ushio Denki Kabushiki Kaisha, Tokyo-to 100-8150 (JP)
(72) Inventor: WASAMOTO, Makoto, Tokyo 1008150 (JP); TAKEMOTO, Fumitoshi, Tokyo 1008150 (JP); SUZUKI, Shinji, Tokyo 1008150 (JP)
(74) Representative: Tomerius, Isabel
(86) International application number: PCT/JP2015/078767
(87) International publication number: WO 2016/060080

(57) **Abstract**

Provided is a workpiece bonding method that makes it possible to achieve a joining state with a high strength and to obtain a good repeatability of the joining state.

A workpiece bonding method according to the present invention is a workpiece bonding method for bonding two workpieces to each other, each of the two workpieces being composed of a material selected from the group consisting of synthetic resin, glass, silicon wafer, crystal and sapphire, the workpiece bonding method including: a surface activation step of activating a bonded surface of at least one of the workpieces; and a laminating step of laminating the two workpieces such that respective bonded surfaces contact with each other, and a pretreatment step of removing moisture from the bonded surface of the workpiece that is to be subjected to the surface activation step is performed before the surface activation step is performed.

## Description

### Technical Field

The present invention relates to a method for bonding workpieces composed of synthetic resin, glass, silicon wafer, crystal or sapphire to each other.

### Background Art

In recent years, in the field of biochemistry, a technique for performing the separation, synthesis, extraction, analysis or the like of a slight amount of reagent using a microreactor has attracted attention. The microreactor is composed of a microchip in which a microscale analysis channel and the like are formed on a small substrate composed of, for example, silicon, silicone resin, glass or the like by a semiconductor microfabrication technology.

A reaction analysis system using such a microreactor is called a micro total analysis system (hereinafter, referred to as a "µTAS"). According to the µTAS, it is possible to perform the reaction analysis at a high speed and a high accuracy, and to realize an automated compact system, because of the increase in the ratio of the surface area of the reagent to the volume, and the like.

In the microchip, regions having various functions, as exemplified by a reaction region where the reagent is put, are on flow passages called microchannels, and thereby, chips suitable for a variety of use purposes can be configured. The use purposes of the microchip include the analysis in the fields of chemistry, biochemistry, pharmacy, medicine and veterinary medicine, as exemplified by genetic analysis, clinical diagnosis and drug screening, and include compound synthesis, environmental measurement and the like.

Such a microchip typically has a structure in which a pair of substrates adhere so as to face each other. Then, a minute flow passage (for example, a width of about ten to several hundreds µm, a depth of about ten to several hundreds µm) is formed on the surface of at least one substrate. As the substrate constituting the microchip, a glass substrate is mainly used because of allowing for an easy production and an optical detection. Further, recently, the development of a microchip using a resin substrate that is lightweight but is not easily broken compared to the glass substrate and that is inexpensive has been advanced.

In the production of the microchip, as the bonding method for the substrates, a method with use of an adhesive and a method by thermal fusion bonding are possible. However, these methods have the following problems.

The bonding method with an adhesive has problems in that the adhesive seeps into the slight flow passage and blocks the flow passage, that a part of the slight flow passage becomes narrow and the diameter of the flow passage becomes uneven, and that the homogeneous property of the wall surface of the flow passage is disturbed.

Further, the bonding method by thermal fusion bonding has a problem in that when the fusion is performed at a thermal fusion temperature or higher, the flow passage collapses at the stage of heating or the flow passage is not held in a predetermined cross-sectional shape, so that it is difficult to obtain a highly functional microchip.

Hence, in recent years, there has been proposed a method of bonding the substrates after activating the surface of a substrate, for example, by emitting a vacuum ultraviolet ray to the surface of the substrate (see Patent Literature 1 to Patent Literature 5). Further, as the method for activating the surface of the substrate, a method of plasmatizing a process gas under the atmospheric pressure or a similar pressure thereto and bringing the plasmatized process gas into contact with the surface of the substrate can be used.

### Citation List

### Patent Literature

Patent Literature 1: Japanese Patent No. 3714338
Patent Literature 2: Japanese Patent Laid-Open No. 2006-187730
Patent Literature 3: Japanese Patent Laid-Open No. 2008-19348
Patent Literature 4: International Publication No. WO 2008/087800A1
Patent Literature 5: Japanese Patent No. 5152361

### Summary of Invention

### Technical Problem

However, it has been found that the conventional bonding method has the following problem. That is, even in the case of accurately controlling substrate surface activation treatment conditions such as the illuminance of the ultraviolet ray to be emitted to the surface of the substrate, the electric power for the plasma treatment of the process gas and the flow rate of the process gas, and joining treatment conditions such as the applying pressure, heating temperature and heating time when the substrates are joined to each other, the obtained joined body varies in joining state, and it is difficult to surely achieve a joining state with a high strength.

Hence, an object of the present invention is to provide a workpiece bonding method that makes it possible to achieve a joining state with a high strength and to obtain a good repeatability of the joining state.

### Solution to Problem

As a result of the keen examination for the above problem, the inventors have found that the joining state of the obtained joined body changes depending on the moisture amount on the bonded surface of the workpiece, and have made the present invention based on the knowledge.

That is, a workpiece bonding method according to the present invention is a workpiece bonding method for bonding two workpieces to each other, each of the two workpieces being composed of a material selected from the group consisting of synthetic resin, glass, silicon wafer, crystal and sapphire, the workpiece bonding method including:
a surface activation step of activating a bonded surface of at least one of the workpieces; and
a joining step of joining the two workpieces in a state where the workpieces are laminated such that respective bonded surfaces contact with each other, and
a pretreatment step of removing moisture from the bonded surface of the workpiece that is to be subjected to the surface activation step is performed before the surface activation step is performed.

In the workpiece bonding method according to the present invention, it is preferable that the pretreatment step be performed by heating the workpiece that is to be subjected to the surface activation step.

Further, it is preferable that the pretreatment step be performed by putting the workpiece that is to be subjected to the surface activation step, in a pressure reduction space.

Further, it is preferable that the pretreatment step be performed by blowing dry air or inert gas to the bonded surface of the workpiece that is to be subjected to the surface activation step.

Further, it is preferable that the surface activation step be an ultraviolet-ray emission treatment step of emitting a vacuum ultraviolet ray to the bonded surface of the workpiece.

Further, it is preferable that the surface activation step be a plasma gas treatment step of bringing a process gas plasmatized under atmospheric pressure into contact with the bonded surface of the workpiece.

### Advantageous Effects of Invention

According to the workpiece bonding method of the present invention, in the pretreatment step for the surface activation step, the moisture is removed from the bonded surface of the workpiece, and therefore, it is possible to achieve a joining state with a high strength and to obtain a good repeatability of the joining state.

### Brief Description of Drawings

[Figure 1] Figure 1 is an explanatory diagram showing an apparatus for executing a pretreatment step by heating a workpiece.
[Figure 2] Figure 2 is an explanatory diagram showing an apparatus for executing the pretreatment step by putting the workpiece in a pressure reduction space.
[Figure 3] Figure 3 is an explanatory diagram showing an apparatus for executing the pretreatment step by blowing a pretreatment gas composed of dry air or inert gas to a bonded surface of the workpiece.
[Figure 4] Figure 4 is an explanatory diagram showing an apparatus for executing the pretreatment step by putting the workpiece under dry atmosphere.
[Figure 5] Figure 5 is an explanatory cross-sectional diagram showing the configuration of an exemplary atmospheric pressure plasma apparatus that is used in the present invention.

### Description of Embodiments

Hereinafter, embodiments of the workpiece bonding method according to the present invention will be described.

### [Workpiece]

For example, a workpiece bonding method according to the present invention is a method of bonding two plate-shaped workpieces to each other. The workpiece that is applied in the bonding method according to the present invention is composed of a material selected from the group consisting of synthetic resin, glass, silicon wafer, crystal and sapphire.

As the synthetic resin composing the workpiece, silicone resin such as polydimethylsiloxane, cycloolefin resin, acrylic resin and the like can be used.

As the glass composing the workpiece, quartz glass, sapphire glass, alkali glass, borosilicate glass and the like can be used.

The two workpieces may be composed of an identical material, or may be composed of different materials. It is preferable that the combination of the materials of the two workpieces be resin-resin, resin-glass, glass-glass, resin-silicon wafer, glass-silicon wafer, or silicon wafer-silicon wafer. Here, a silicon oxide film may be formed on the surface of the silicon wafer.

### [Steps]

The workpiece bonding method according to the present invention includes a surface activation step of activating a bonded surface of at least one of the workpieces, and a joining step of joining the two workpieces in a state where the workpieces are laminated such that the respective bonded surfaces contact with each other. The surface activation step may be performed only for one workpiece, but preferably should be performed for both of the two workpieces.

Then, in the workpiece bonding method according to the present invention, a pretreatment step of removing moisture from the bonded surface of the workpiece that is to be subjected to the surface activation step is performed before the surface activation step is performed.

### [Pretreatment Step]

The pretreatment step only has to be performed for the workpiece that is to be subjected to the surface activation step, but may be performed for both of the two workpieces in the case where the surface activation step is performed only for one workpiece.

The treatment method for executing the pretreatment step is not particularly limited as long as the method removes moisture from the bonded surface of the workpiece. Specific examples of the treatment method include (1) a method of heating the workpiece, (2) a method of putting the workpiece in a pressure reduction space, (3) a method of blowing a pretreatment gas composed of dry air or inert gas to the bonded surface of the workpiece, and (4) a method of putting the workpiece under dry atmosphere. Among them, the methods (1), (2) and (3) are preferable.

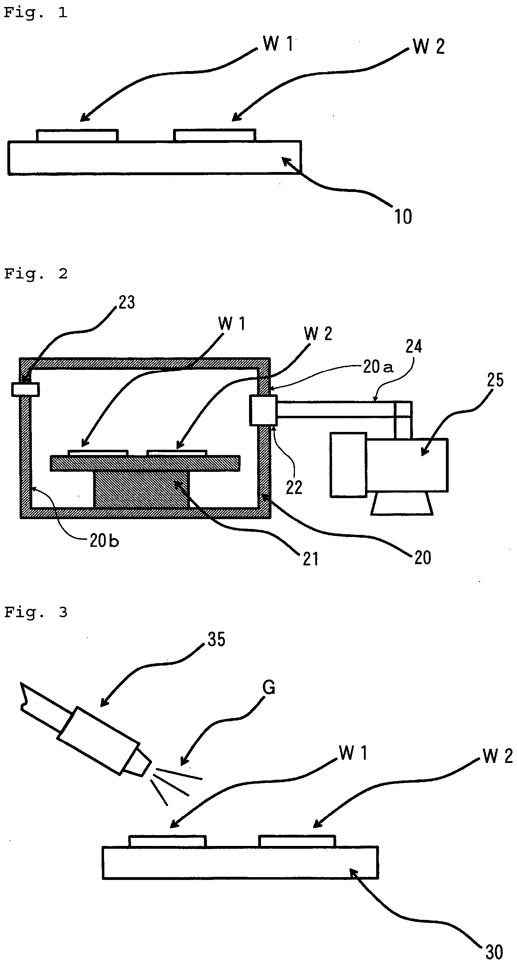

Figure 1 is an explanatory diagram showing an apparatus for executing the pretreatment step by heating the workpiece. The apparatus includes a hotplate 10 that heats workpieces W1, W2. In the apparatus, the plate-shaped workpieces W1, W2 are placed on the hotplate 10, and are directly heated by the hotplate 10.

The heating condition of the workpiece W is appropriately set depending on the materials composing the workpieces W1, W2. The heating temperature preferably should be equal to or higher than 75°C, and more preferably should be equal to or higher than 100°C, which is the boiling point of water.

As a specific heating condition, for example, in the case where the workpiece W1 or the workpiece W2 is composed of synthetic resin, the heating temperature is 100 to 110°C and the heating time is 30 to 300 seconds.

Further, in the case where the workpiece W1 and the workpiece W2 are composed of glass, silicon wafer, crystal or sapphire, the heating temperature is 120 to 140°C and the heating time is 30 to 300 seconds.

Figure 2 is an explanatory diagram showing an apparatus for executing the pretreatment step by putting the workpiece in a pressure reduction space. In the apparatus, a stage 21 on which the workpieces W1, W2 are placed is provided in a box-shaped rectangular chamber 20. A vacuum valve 22 is provided on one sidewall 20a of the chamber 20. Further, a leak port 23 is provided on another sidewall 20b of the chamber 20. A vacuum pump 25 is connected with the vacuum valve 22 through a pipe 24.

In the apparatus shown in Figure 2, the plate-shaped workpieces W1, W2 are placed on the stage 21 such that the bonded surfaces are oriented upward. Thereafter, the vacuum pump 25 is driven, and thereby, the interior of the chamber 20 becomes a pressure reduction space.

The atmosphere pressure of the pressure reduction space in the chamber 20 is 1000 Pa or lower, for example.

Further, the treatment time during which the workpieces W1, W2 are put in the pressure reduction space is 1 to 5 minutes, for example.

Figure 3 is an explanatory diagram showing an apparatus for executing the pretreatment step by blowing a pretreatment gas composed of dry air or inert gas to the bonded surface of the workpiece. In the apparatus, an injection nozzle 35 that injects a pretreatment gas G is disposed above a stage 30 on which the workpieces W1, W2 are placed.

As the dry air composing the pretreatment gas G, it is preferable to use an air having a dew point of -40°C or lower.

Further, as the inert gas composing the pretreatment gas G, nitrogen gas, argon gas and the like can be used.

In the apparatus shown in Figure 3, the plate-shaped workpieces W1, W2 are placed on the stage 30 such that the bonded surfaces are oriented upward. Thereafter, the pretreatment gas G is injected from the injection nozzle 35 to the bonded surfaces of the workpieces W1, W2.

It is preferable that the flow rate of the pretreatment gas G blown to the workpieces W1, W2 be 0.03 to 0.12 m³/min.

Further, the treatment time during which the pretreatment gas G is blown to the workpieces W1, W2 is 5 to 300 seconds, for example.

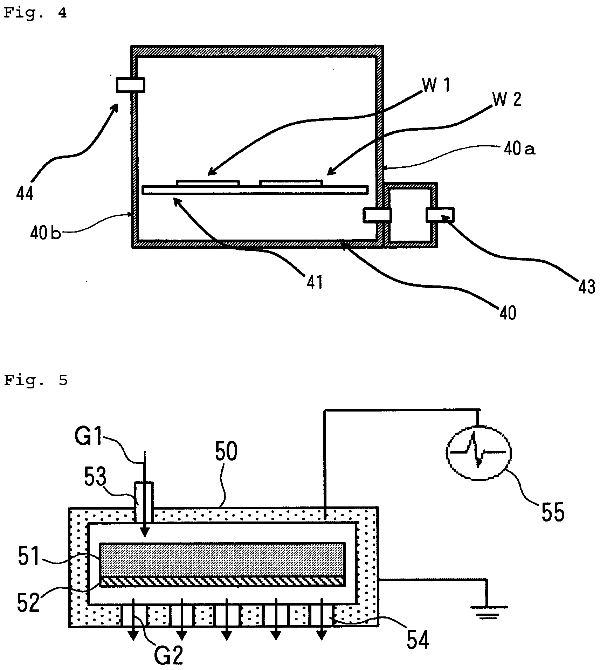

Figure 4 is an explanatory diagram showing an apparatus for executing the pretreatment step by putting the workpiece under dry atmosphere. In the apparatus, a tray 41 on which the workpieces W1, W2 are placed is provided in a box-shaped rectangular container 40. Further, a gas feed port 43 from which the dry air is fed is provided so as to be adjacent to one sidewall 40a of the container 40. Further, a gas exhaust port 44 from which the gas in the container 40 is exhausted is provided on another sidewall 40b of the container 40.

In the apparatus shown in Figure 4, the plate-shaped workpieces W1, W2 are placed on the tray 41 such that the bonded surfaces are oriented upward. Then, the tray 41 having the workpieces W1, W2 placed is put in the container 40. Thereafter, the dry air is fed from the gas feed port 43 into the container 40, and thereby, the interior of the container 40 becomes a dry atmosphere.

It is preferable that the dry atmosphere in the container 40 have a relative humidity of 5% or lower, and have a dew point of -20°C or lower when the treatment temperature is the normal temperature (20°C), for example. The degree of the dry atmosphere in the container 40 can be estimated by measuring the dew point of the gas exhausted from the gas exhaust port 44, by a dew-point meter (not illustrated).

Further, the treatment time during which the workpieces W1, W2 are put under the dry atmosphere is 1 to 5 minutes, for example.

In the workpiece bonding method according to the present invention, it is preferable that the moisture amount by mass of the workpiece after the completion of the pretreatment step is 0.12% or less. In the case where the moisture amount by mass exceeds 0.12%, it is sometimes difficult to surely achieve a joining state with a high strength when the workpieces are bonded to each other.

Here, the moisture amount by mass can be measured by a heat drying type moisture meter.

Further, it is preferable that the time after the completion of the pretreatment step and before the start of the surface activation step be 10 minutes or less. In the case where the time exceeds 10 minutes, there is a concern that moisture is reattached to the surface of the pretreated workpiece. Therefore, it is sometimes difficult to surely achieve a joining state with a high strength in the obtained joined body.

### [Surface Activation Step]

It is preferable that the surface activation step be an ultraviolet-ray emission treatment step of emitting a vacuum ultraviolet ray to the bonded surface of the workpiece, or a plasma gas treatment step of bringing a process gas plasmatized under atmospheric pressure into contact with the bonded surface of the workpiece.

### (1) Ultraviolet-Ray Emission Treatment Step

In the case where the ultraviolet-ray treatment step is selected as the surface activation step, a vacuum ultraviolet ray having a wavelength of 200 nm or less is emitted to the bonded surface of the pretreated workpiece.

As a light source that emits the vacuum ultraviolet ray, an excimer lamp such as a xenon excimer lamp having a bright line at a wavelength of 172 nm, a low pressure mercury lamp having a bright line at a wavelength of 185 nm, and a deuterium lamp having a bright line in a wavelength range of 120 to 200 nm can be suitably used.

The illuminance of the vacuum ultraviolet ray to be emitted to the bonded surface of the workpiece is 10 to 100 mW/cm², for example.

Further, the time of the emission of the ultraviolet ray to the bonded surface of the workpiece, which is appropriately set depending on the material composing the workpiece, is 5 to 120 seconds, for example.

### (2) Plasma Gas Treatment Step

In the case where the plasma gas treatment step is selected as the surface activation step, the process gas plasmatized under atmospheric pressure is brought into contact with the bonded surface of the workpiece.

Figure 5 is an explanatory cross-sectional diagram showing the configuration of an exemplary atmospheric pressure plasma apparatus that is used in the present invention. The atmospheric pressure plasma apparatus includes a rectangular parallelepiped casing 50 composed of aluminum, for example. A plate-shaped electrode 51 electrically connected with a high frequency power source 55 is horizontally disposed in the casing 50. A dielectric layer 52 is formed on the lower surface of the electrode 51. In the atmospheric pressure plasma apparatus in the example, the electrode 51 is a high-voltage-side electrode, and the casing 50 is a ground-side electrode.

A gas supply port 53 from which the process gas is supplied into the casing 50 is provided on the upper surface of the casing 50. Further, a plurality of nozzles 54 for releasing the process gas plasmatized under atmospheric pressure in the casing 50 to the exterior is formed on the lower surface of the casing 50.

In such an atmospheric pressure plasma apparatus, the process gas G1 is supplied from the gas supply port 53 into the casing 50 under the atmospheric pressure or a similar pressure thereto. In this state, when the high frequency power source 55 applies a high frequency electric field between the electrode 51 and the casing 50 through the dielectric layer 52, a dielectric-barrier discharge occurs between the electrode 51 and the casing 50. As a result, the process gas G1 existing between the casing 50 and the dielectric layer 52 is ionized or excited to plasmatize. Then, the plasmatized process gas G2 is released from the nozzles 54 of the casing 50 to the exterior, and comes into contact with the bonded surface of the workpiece (not illustrated) that is put below the casing 50.

In the above, as the process gas G1, it is preferable to use a gas that is mainly composed of nitrogen gas, argon gas or the like and that contains 0.01 to 5 volume percent oxygen gas. Alternatively, a mixed gas of nitrogen gas and clean dry air (CDA) can be used.

Further, as for the electric power that is supplied from the high frequency power source 55, the frequency is 20 to 70 kHz and the voltage is 5 to 15 kVp-p.

Further, the treatment time of the plasma gas treatment is 5 to 100 seconds, for example.

### [Joining Step]

In the joining step, the two workpieces are joined in a state where the workpieces are laminated such that the respective bonded surfaces contact with each other.

Specific methods for joining the workpieces to each other include (1) a method of heating the two workpieces in a state where the workpieces are laminated, (2) a method of compressing the two workpieces in the thickness direction in a state where the workpieces are laminated, (3) a method of heating the two workpieces while compressing the workpieces in the thickness direction in a state where the workpieces are laminated, and (4) a method of compressing the two workpieces in the thickness direction in a state where the workpieces are laminated and then heating the workpieces after the stop of the compression.

The specific condition in the joining step is appropriately set in a range in which the workpieces do not deform, depending on the materials composing the workpieces.

As a specific heating condition, in the case of heating the two workpieces, when one workpiece is composed of synthetic resin, the heating temperature is 100 to 110°C. Further, when both of the two workpieces are composed of glass, silicon wafer, crystal or sapphire, the heating temperature is 120 to 140°C.

Further, in the case of compressing the two workpieces, when one workpiece is composed of synthetic resin, the compression force is 0.2 to 10 MPa. Further, when both of the two workpieces are composed of glass, silicon wafer, crystal or sapphire, the compression force is 1 to 10 MPa.

According to the above workpiece bonding method, in the pretreatment step for the surface activation step, the moisture is removed from the bonded surface of the workpiece, and therefore, it is possible to achieve a joining state with a high strength and to obtain a good repeatability of the joining state.

### Examples

Hereinafter, specific examples of the workpiece bonding method according to the present invention will be described. The present invention is not limited to the following examples.

### [Making of Workpiece]

The following workpiece A and workpiece B were made.

The workpiece A was composed of cycloolefin resin ("ZEONEX 480R" manufactured by Zeon Corporation), and was a plate-shaped rectangular workpiece having dimensions of 30 mm x 30 mm x 3 mm.

The workpiece B was composed of synthetic quartz glass, and was a plate-shaped rectangular workpiece having dimensions of 25 mm x 45 mm x 2 mm.

The moisture amount by mass of each of the workpiece A and the workpiece B was measured by a heat drying type moisture meter (manufactured by A&D Company, Limited). The heat drying type moisture meter heated a sample placed on an electronic balance in the moisture meter, measured the mass change of the sample by the balance, and evaluated the reduction amount of the sample mass by the heat drying, as the moisture. As a result, the moisture amount by mass of the workpiece A was 0.13%, and the moisture amount by mass of the workpiece B was 0.07%.

### <Example 1>

The workpiece A was used as one workpiece, and the workpiece B was used as the other workpiece. The two workpieces were bonded by performing the following pretreatment step, ultraviolet-ray emission treatment step and joining step.

### [Pretreatment Step]

Using the apparatus shown in Figure 1, the pretreatment step was performed by heating each of the two workpieces under the condition of a heating temperature 75°C and a heating time of 5 minutes. After the pretreatment step, the moisture amount by mass of each of the workpiece A and the workpiece B was measured by the heat drying type moisture meter (manufactured by A&D Company, Limited). The result is shown in Table 1.

### [Ultraviolet-Ray Emission Treatment Step]

Using a xenon excimer lamp, a vacuum ultraviolet ray was emitted to one surface (bonded surface) of each of the two workpieces, under the condition of an illuminance of 40 mW/cm² and an emission time of 30 seconds.

### [Joining Step]

The two workpieces were laminated such that the respective one surfaces contacted with each other. Here, the contact area in the mutual contact on the one surface of each of the two workpieces was 625 mm². Subsequently, the two workpieces were joined by compression, under the condition of a compression force of 2 MPa and a compression time of 300 seconds.

The tensile shear adhesion strength of the obtained joined body was measured in compliance with JIS K 6850. The result is shown in Table 1.

### <Example 2>

The two workpieces were bonded in the same way as Example 1, except that the heating temperature was changed into 100°C in the pretreatment step. The moisture amount by mass of each of the two workpieces after the pretreatment step is shown in Table 1.

The tensile shear adhesion strength of the obtained joined body was measured in compliance with JIS K 6850. The result is shown in Table 1.

### <Example 3>

The two workpieces were bonded in the same way as Example 1, except that the heating temperature was changed into 120°C in the pretreatment step. The moisture amount by mass of each of the two workpieces after the pretreatment step is shown in Table 1.

The tensile shear adhesion strength of the obtained joined body was measured in compliance with JIS K 6850. The result is shown in Table 1.

### <Example 4>

The two workpieces were bonded in the same way as Example 1, except that the pretreatment step was performed as follows. The moisture amount by mass of each of the two workpieces after the pretreatment step is shown in Table 1.

The tensile shear adhesion strength of the obtained joined body was measured in compliance with JIS K 6850. The result is shown in Table 1.

### [Pretreatment Step]

Using the apparatus shown in Figure 2, the pretreatment step was performed by putting each of the two workpieces in a pressure reduction space in which the atmosphere pressure was 133 Pa, for 5 minutes.

### <Example 5>

The two workpieces were bonded in the same way as Example 1, except that the pretreatment step was performed as follows. The moisture amount by mass of each of the two workpieces after the pretreatment step is shown in Table 1.

The tensile shear adhesion strength of the obtained joined body was measured in compliance with JIS K 6850. The result is shown in Table 1.

### [Pretreatment Step]

Using the apparatus shown in Figure 3, the pretreatment step was performed by blowing nitrogen gas to the one surface (bonded surface) of each of the two workpieces for 5 minutes, under the condition of a flow rate of 0.03 m³/min.

### <Example 6>

The two workpieces were bonded in the same way as Example 1, except that the pretreatment step was performed as follows. The moisture amount by mass of each of the two workpieces after the pretreatment step is shown in Table 1.

The tensile shear adhesion strength of the obtained joined body was measured in compliance with JIS K 6850. The result is shown in Table 1.

### [Pretreatment Step]

Using the apparatus shown in Figure 4, the pretreatment step was performed by putting each of the workpiece A and the workpiece B under a dry atmosphere having a relative humidity of 5% (the dew point is -20°C) at a temperature of 20°C for 5 minutes.

### <Comparative Example 1>

The two workpieces were bonded in the same way as Example 1, except that the pretreatment step was not performed.

The tensile shear adhesion strength of the obtained joined body was measured in compliance with JIS K 6850. The result is shown in Table 1.

### <Example 7>

The two workpieces were bonded in the same way as Example 1, except that the workpiece A was used as the other workpiece instead of the workpiece B.

The tensile shear adhesion strength of the obtained joined body was measured in compliance with JIS K 6850. The result is shown in Table 1.

### <Example 8>

The two workpieces were bonded in the same way as Example 2, except that the workpiece A was used as the other workpiece instead of the workpiece B.

The tensile shear adhesion strength of the obtained joined body was measured in compliance with JIS K 6850. The result is shown in Table 1.

### <Example 9>

The two workpieces were bonded in the same way as Example 3, except that the workpiece A was used as the other workpiece instead of the workpiece B.

The tensile shear adhesion strength of the obtained joined body was measured in compliance with JIS K 6850. The result is shown in Table 1.

### <Example 10>

The two workpieces were bonded in the same way as Example 4, except that the workpiece A was used as the other workpiece instead of the workpiece B.

The tensile shear adhesion strength of the obtained joined body was measured in compliance with JIS K 6850. The result is shown in Table 1.

### <Example 11>

The two workpieces were bonded in the same way as Example 5, except that the workpiece A was used as the other workpiece instead of the workpiece B.

The tensile shear adhesion strength of the obtained joined body was measured in compliance with JIS K 6850. The result is shown in Table 1.

### <Example 12>

The two workpieces were bonded in the same way as Example 6, except that the workpiece A was used as the other workpiece instead of the workpiece B.

The tensile shear adhesion strength of the obtained joined body was measured in compliance with JIS K 6850. The result is shown in Table 1.

### <Comparative Example 2>

The two workpieces were bonded in the same way as Comparative Example 1, except that the workpiece A was used as the other workpiece instead of the workpiece B.

The tensile shear adhesion strength of the obtained joined body was measured in compliance with JIS K 6850. The result is shown in Table 1.

### <Example 13>

The two workpieces were bonded in the same way as Example 1, except that the workpiece B was used as the one workpiece instead of the workpiece A.

The tensile shear adhesion strength of the obtained joined body was measured in compliance with JIS K 6850. The result is shown in Table 1.

### <Example 14>

The two workpieces were bonded in the same way as Example 2, except that the workpiece B was used as the one workpiece instead of the workpiece A.

The tensile shear adhesion strength of the obtained joined body was measured in compliance with JIS K 6850. The result is shown in Table 1.

### <Example 15>

The two workpieces were bonded in the same way as Example 3, except that the workpiece B was used as the one workpiece instead of the workpiece A.

The tensile shear adhesion strength of the obtained joined body was measured in compliance with JIS K 6850. The result is shown in Table 1.

### <Example 16>

The two workpieces were bonded in the same way as Example 4, except that the workpiece B was used as the one workpiece instead of the workpiece A.

The tensile shear adhesion strength of the obtained joined body was measured in compliance with JIS K 6850. The result is shown in Table 1.

### <Example 17>

The two workpieces were bonded in the same way as Example 5, except that the workpiece B was used as the one workpiece instead of the workpiece A.

The tensile shear adhesion strength of the obtained joined body was measured in compliance with JIS K 6850. The result is shown in Table 1.

### <Example 18>

The two workpieces were bonded in the same way as Example 6, except that the workpiece B was used as the one workpiece instead of the workpiece A.

The tensile shear adhesion strength of the obtained joined body was measured in compliance with JIS K 6850. The result is shown in Table 1.

### <Comparative Example 3>

The two workpieces were bonded in the same way as Comparative Example 1, except that the workpiece B was used as the one workpiece instead of the workpiece A.

The tensile shear adhesion strength of the obtained joined body was measured in compliance with JIS K 6850. The result is shown in Table 1.

### <Example 19>

The two workpieces were bonded in the same way as Example 8, except that the following plasma gas treatment step was performed instead of the ultraviolet-ray emission treatment step.

The tensile shear adhesion strength of the obtained joined body was measured in compliance with JIS K 6850. The result is shown in Table 1.

### [Atmospheric Pressure Plasma Apparatus]

The atmospheric pressure plasma apparatus shown in Figure 5 and having the following specification was prepared.
Material of casing: Aluminum
Material of electrode: A super invar in which a film composed of alumina and having a thickness of 500 µm was formed on the surface by thermal spraying
Dimensions of electrode: 50 mm x 300 mm
Clearance between casing and dielectric layer: 0.5 mm
Voltage: 7.0 kVp-p
Frequency: 60 kHz
Rated power: 1100 VA

### [Plasma Gas Treatment Step]

The workpiece was put at a position 2 mm away from the nozzles below the above atmospheric pressure plasma apparatus, such that the one surface (bonded surface) faced the nozzles. Then, as the process gas, nitrogen gas with a flow rate of 150 L/min and clean dry air (the oxygen concentration in the process gas is about 0.14 volume percent) with a flow rate of 1 L/min were supplied into the casing, and therewith, the atmospheric pressure plasma apparatus was actuated. Thereby, the plasma gas treatment of the one surface of the workpiece was performed for 15 seconds.

### <Example 20>

The two workpieces were bonded in the same way as Example 9, except that the plasma gas treatment step under the same condition as Example 19 was performed instead of the ultraviolet-ray emission treatment step.

The tensile shear adhesion strength of the obtained joined body was measured in compliance with JIS K 6850. The result is shown in Table 1.

### <Comparative Example 4>

The two workpieces were bonded in the same way as Comparative Example 2, except that the plasma gas treatment step under the same condition as Example 19 was performed instead of the ultraviolet-ray emission treatment step.

The tensile shear adhesion strength of the obtained joined body was measured in compliance with JIS K 6850. The result is shown in Table 1.

**[Table 1]**

| | Type of workpiece | | Pretreatment | Surface activation step | Moisture amount by mass (%) | | Tensile shear adhesion strength (MPa) |
|---|---|---|---|---|---|---|---|
| | One workpiece | The other workpiece | | | One workpiece | The other workpiece | |
| Example 1 | Workpiece A | Workpiece B | Heating (75°C) | Ultraviolet-ray emission treatment step | 0.10 | 0.05 | 0.095 |
| Example 2 | Workpiece A | Workpiece B | Heating (100°C) | Ultraviolet-ray emission treatment step | 0.09 | 0.04 | 0.127 |
| Example 3 | Workpiece A | Workpiece B | Heating (125°C) | Ultraviolet-ray emission treatment step | 0.07 | 0.05 | 0.101 |
| Example 4 | Workpiece A | Workpiece B | Putting in pressure reduction space | Ultraviolet-ray emission treatment step | 0.12 | 0.05 | 0.094 |
| Example 5 | Workpiece A | Workpiece B | Gas blowing | Ultraviolet-ray emission treatment step | 0.12 | 0.06 | 0.072 |
| Example 6 | Workpiece A | Workpiece B | Putting under dry atmosphere | Ultraviolet-ray emission treatment step | 0.13 | 0.06 | 0.067 |
| Comparative Example 1 | Workpiece A | Workpiece B | No | Ultraviolet-ray emission treatment step | 0.13 | 0.07 | 0.055 |
| Example 7 | Workpiece A | workpiece A | Heating (75°C) | Ultraviolet-ray emission treatment step | 0.10 | 0.10 | 0.142 |
| Example 8 | Workpiece A | Workpiece A | Heating (100°C) | Ultraviolet-ray emission treatment step | 0.09 | 0.09 | 0.146 |
| Example 9 | Workpiece A | Workpiece A | Heating (125°C) | Ultraviolet-ray emission treatment step | 0.07 | 0.07 | 0.148 |
| Example 10 | Workpiece A | Workpiece A | Putting in pressure reduction space | Ultraviolet-ray emission treatment step | 0.12 | 0.12 | 0.128 |
| Example 11 | Workpiece A | Workpiece A | Gas blowing | Ultraviolet-ray emission treatment step | 0.12 | 0.12 | 0.115 |
| Example 12 | Workpiece A | Workpiece A | Putting under dry atmosphere | Ultraviolet-ray emission treatment step | 0.13 | 0.13 | 0.125 |
| Comparative Example 2 | Workpiece A | Workpiece A | No | Ultraviolet-ray emission treatment step | 0.13 | 0.13 | 0.112 |
| Example 13 | Workpiece B | Workpiece B | Heating (75°C) | Ultraviolet-ray emission treatment step | 0.05 | 0.05 | 0.079 |
| Example 14 | Workpiece B | Workpiece B | Heating (100°C) | Ultraviolet-ray emission treatment step | 0.04 | 0.04 | 0.099 |
| Example 15 | Workpiece B | Workpiece B | Heating (125°C) | Ultraviolet-ray emission treatment step | 0.05 | 0.05 | 0.108 |
| Example 16 | Workpiece B | Workpiece B | Putting in pressure reduction space | Ultraviolet-ray emission treatment step | 0.05 | 0.05 | 0.080 |
| Example 17 | Workpiece B | Workpiece B | Gas blowing | Ultraviolet-ray emission treatment step | 0.06 | 0.06 | 0.069 |
| Example 18 | Workpiece B | Workpiece B | Putting under dry atmosphere | Ultraviolet-ray emission treatment step | 0.06 | 0.06 | 0.080 |
| Comparative Example 3 | Workpiece B | workpiece B | No | Ultraviolet-ray emission treatment step | 0.07 | 0.07 | 0.071 |
| Example 19 | Workpiece A | Workpiece A | Heating (100°C) | Plasma gas treatment step | 0.09 | 0.09 | 0.145 |
| Example 20 | Workpiece A | Workpiece A | Heating (125°) | Plasma gas treatment step | 0.07 | 0.07 | 0.152 |
| Comparative Example 4 | Workpiece A | Workpiece A Workpiece A No | No | Plasma gas treatment step | 0.13 | 0.13 | 0.075 |

As is clear from the result in Table 1, according to the bonding methods in Examples 1 to 20, it is possible to achieve a joining state with a high strength in the obtained joined body.

### Reference Signs List

- 10: hotplate
- 20: chamber
- 20a: one sidewall
- 20b: another sidewall
- 21: stage
- 22: vacuum valve
- 23: leak port
- 24: pipe
- 25: vacuum pump
- 30: stage
- 35: injection nozzle
- 40: container
- 40a: one sidewall
- 40b: another sidewall
- 41: tray
- 43: gas feed port
- 44: gas exhaust port
- 50: casing
- 51: electrode
- 52: dielectric layer
- 53: gas supply port
- 54: nozzle
- 55: high frequency power source
- G: pretreatment gas
- G1: process gas
- G2: plasmatized process gas
- W1, W2: workpiece

## Claims

1. A workpiece bonding method for bonding two workpieces to each other, each of the two workpieces being composed of a material selected from the group consisting of synthetic resin, glass, silicon wafer, crystal and sapphire, the workpiece bonding method comprising:
a surface activation step of activating a bonded surface of at least one of the workpieces; and
a joining step of joining the two workpieces in a state where the workpieces are laminated such that respective bonded surfaces contact with each other, and
a pretreatment step of removing moisture from the bonded surface of the workpiece that is to be subjected to the surface activation step is performed before the surface activation step is performed.

2. The workpiece bonding method according to claim 1, wherein the pretreatment step is performed by heating the workpiece that is to be subjected to the surface activation step.

3. The workpiece bonding method according to claim 1, wherein the pretreatment step is performed by putting the workpiece that is to be subjected to the surface activation step, in a pressure reduction space.

4. The workpiece bonding method according to claim 1, wherein the pretreatment step is performed by blowing dry air or inert gas to the bonded surface of the workpiece that is to be subjected to the surface activation step.

5. The workpiece bonding method according to any one of claims 1 to 4, wherein the surface activation step is an ultraviolet-ray emission treatment step of emitting a vacuum ultraviolet ray to the bonded surface of the workpiece.

6. The workpiece bonding method according to any one of claims 1 to 4, wherein the surface activation step is a plasma gas treatment step of bringing a process gas plasmatized under atomospheric pressure into contact with the bonded surface of the workpiece.
